# EUROPEAN PATENT APPLICATION

(11) **EP 2 355 240 A1**
(43) Date of publication of application: **10.08.2011**
(21) Application number: 10152070.8
(22) Date of filing: 29.01.2010
(51) Int. Cl.: H01Q 1/24, H01Q 1/50, H01Q 9/42, H01Q 23/00, H04B 1/18

(54) **Antenna device and portable electronic device comprising such an antenna device**

(71) Applicant: Laird Technologies AB, 164 22 Kista (SE)
(72) Inventor: Irmscher, Stefan, 191 41 Sollentuna (SE); Kaikkonen, Andrei, 175 48 Järfälla (SE); Lindberg, Peter, 752 29 Uppsala (SE); Luan, Yuantao, 100176 Beijing (CN); Trossing, Martin, 187 32 Täby (SE)
(74) Representative: Dahnér, Christer

(57) **Abstract**

An antenna device (18) for a portable electronic device, preferably for the FM frequency range, comprises a monopole radiating and/or radiation receiving element (24) having a capacitance and including a feeding point (26), an amplifier stage (28) having an input coupled to the feeding point, where the input of the amplifier stage is connectable to ground via a biasing branch comprising a bias voltage source (30) and a choke inductor (32) and the amplifier stage has an output connectable to a radio circuit (22), and a matching element (38) coupled between the feeding point and the amplifier stage. The monopole element, choke inductor and matching element are part of a resonance circuit, the resonance frequency of which is matched to a frequency in the FM frequency range by the antenna matching element.

## Description

### FIELD OF INVENTION

The present invention relates generally to antenna devices and more particularly to an antenna device for use in a portable electronic device, such as a mobile phone, which is adapted for radio signals having a relatively low frequency, such as radio signals in the FM band. The present invention also relates to a portable electronic device having such an antenna device.

### BACKGROUND

Internal antennas have been used for some time in portable radio communication devices. There are a number of advantages connected with using internal antennas, of which can be mentioned that they are small and light, making them suitable for applications wherein size and weight are of importance, such as in mobile phones.

However, the application of internal antennas in a mobile phone puts some constraints on the configuration of the antenna element. In particular, in a portable radio communication device the space for an internal antenna arrangement is limited. These constraints may make it difficult to find a configuration of the antenna that provides for a wide operating band. This is especially true for antennas intended for use with radio signals of relatively low frequencies as the desired physical length of such antennas are large compared to antennas operating with relatively high frequencies.

One specific application operating in a relatively low frequency band is the FM radio application. The FM band is defined as frequencies between 88-108 MHz in Europe or between 76-110 MHz in the USA. Prior art conventional antenna configurations, such as loop antennas or monopole antennas, fitted within the casing of a portable radio communication device will result in unsatisfactory operation in that the antenna either has too bad performance over a sufficiently wide frequency band or sufficient performance over a too narrow frequency band.

Because of this so-called active antennas have been developed. An active antenna is an antenna device that includes a short radiating or radiation receiving element together with an amplifier stage.

Such an antenna device having an amplifier stage together with a monopole element in the interior of a portable electronic device is for instance known through EP 1965503 and EP 1965502.

Some of the amplifiers that may be used in such an antenna device need to include a bias voltage source connected to the input of the amplifier stage, which source is a DC source. However, then it is necessary that this source does not influence the radio signal reception. Countermeasures do then have to be applied for stopping the bias voltage source from influencing radio signal reception. There is thus a need for means of isolating the bias voltage from the radio signal reception. However these countermeasures do in turn also influence the performance of the antenna device. It is therefore a need for providing an improved antenna device that can provide operation in a desired operating frequency band also when an amplifier stage requiring a DC voltage bias is used.

### SUMMARY OF THE INVENTION

An object of the present invention is to provide an internal antenna device for use in a portable electronic device, which operates with sufficient performance throughout a frequency band having a relatively low frequency, such as the FM radio band for an antenna device having an amplifier stage needing a bias voltage and having means for isolating the bias voltage from the radio signal reception.

The invention is based on the realization that a choke inductor provided in relation to a bias voltage source can be used for providing resonance for a monopole radiating or radiation receiving element that would not otherwise resonate.

According to the present invention there is provided an antenna device for receiving radio signals in at least one operating frequency band and for being provided in the interior of a portable electronic device, the antenna device comprising
a monopole radiating and/or radiation receiving element having a capacitance and including a feeding point,
an amplifier stage having an input coupled to the feeding point, the input of the amplifier stage being connectable to ground via a biasing branch comprising a bias voltage source and a choke inductor, the amplifier stage having an output connectable to a radio circuit, and
a matching element coupled between the feeding point and the amplifier stage,
wherein the monopole element, choke inductor and matching element are part of a resonance circuit, the resonance frequency of which is matched to a frequency in said operating frequency band by the antenna matching element.

A portable electronic device comprising such an antenna device for receiving radio signals in at least a first operating frequency band and a radio circuit connected to the antenna device is also provided.

The antenna device according to the invention provides operation with good performance throughout a frequency band having a relatively low frequency, such as the FM radio band. By using a monopole antenna, it has been found that the sensitivity is improved across the entire operating frequency range, giving good signal to noise ratio. The choke inductor and matching element provided between the monopole element and amplifier stage increases source resistance seen by the amplifier stage, thus matching noise and increasing stability.

Further preferred embodiments are defined in the dependent claims.

The term "connected" that is being used here is intended to mean a direct connection between two entities. There are thus no entities between them. The term "coupled" being used here is intended to cover a connection between two entities that can be direct as well as indirect. There may thus be other entities placed in a path between two entities coupled to each other.

### BRIEF DESCRIPTION OF DRAWINGS

The invention is now described, by way of example, with reference to the accompanying drawings, in which:
Fig. 1 shows a front view of a portable electronic device according to the present invention;
Fig. 2 shows a sectional view of the portable electronic device according to the present invention;
Fig. 3 is a schematic perspective view of a monopole element of the antenna device in relation to a ground plane,
FIG. 4 shows a circuit diagram of an antenna device according to the invention connected to a radio circuit;
FIG. 5 shows the amplifier stage in more detail;
FIG. 6 shows a first resonance circuit according to the invention being formed by some of the elements of the antenna device and connected to the amplifier stage; and
Fig. 7 shows a second resonance circuit according to the invention being formed by some of the elements of the antenna device and connected to the amplifier stage.

### DETAILED DESCRIPTION OF THE INVENTION

In the following, a detailed description of a preferred embodiment of an antenna device and portable electronic device according to the invention will be given. In the description, for purposes of explanation and not limitation, specific details are set forth, in order to provide a thorough understanding of the present invention. However, it will be apparent to one skilled in the art that the present invention may be utilized in other embodiments that depart from these specific details. In other instances, detailed descriptions of well-known units, entities and circuits are omitted so as not to obscure the description of the present invention with unnecessary details.

The invention is generally directed towards an antenna device and a portable electronic device including an antenna device, where the antenna device is supposed to receive radio signals in an operating frequency band.

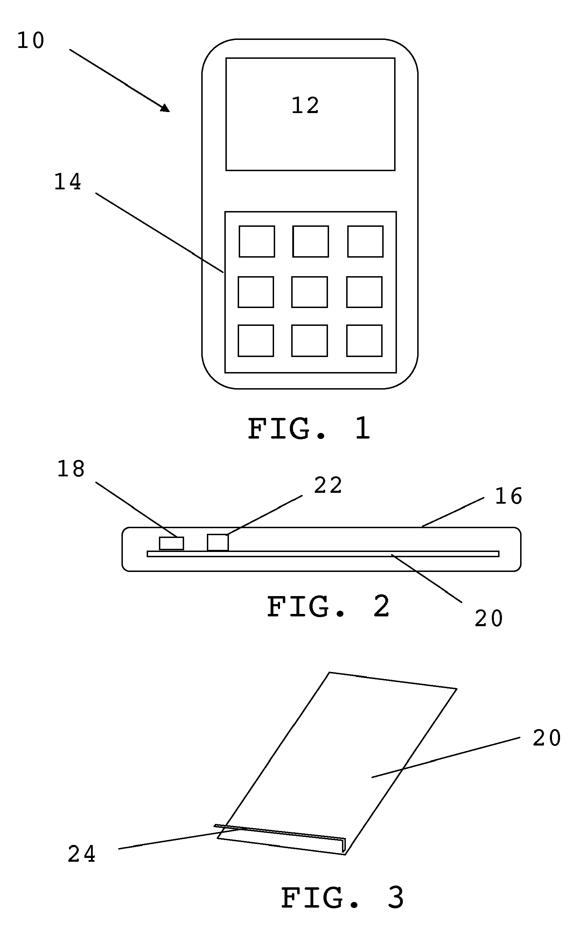

Fig. 1 shows a front view of a portable electronic device 10, such as a mobile phone. The portable electronic device can however be another type of device, such as a lap top computer, a palm top computer, an electronic organizer such as a personal digital assistant (PDA), a game console, a small clock, such as a travel alarm clock, a TV receiver, an FM radio receiver or a media player such as an MP3 or a CD player. The device 10 is, as an example, provided with a display 12 placed close to an upper end of the device and a keypad 14 placed close to a lower end of the device. These are here provided on the casing of the device 10. It should however be realized that the device may just as well be provided without a display and/or without a keypad. The device 10 is also provided with at least one antenna. However, all antennas are provided inside the device, i.e. in the interior of the device.

Fig. 2 shows a schematic side view of the device 10, which is a cross section through the casing 16. In order to clarify the description of the present invention only elements that are necessary for understanding the present invention are included. Thus a number of units in the device have here been omitted, like for instance the display and the keypad shown in fig. 1. The device 10 here includes a circuit board 20 on which an antenna device 18 according to the present invention is mounted. On the board 20 there is furthermore a radio circuit 22, here in the form of an FM receiver circuit, which may for instance be used to demodulate radio signals received by the antenna device. The circuit board 20, which may be a multi-layer PCB (printed circuit board), furthermore includes a ground plane (not shown), which is used together with the antenna device 18 of the present invention. The antenna device includes a monopole radiating and/or radiation receiving element. Such an element is sometimes also referred to as radiator.

Fig. 3 shows a perspective view of this monopole element 24 and the circuit board 20. The circuit board 20 may extend over an area that is limited by a number of corners. It may typically be rectangular in shape and thus have four corners. The monopole element 24 may be connected to the rest of the antenna device adjacent one of these corners of the circuit board 20. With such a placing the monopole element 24 may stretch out across the board 20 from one long side to an opposite long side. The monopole element 24 may also stretch along a short side of the circuit board 20 that is provided at the upper or lower end of the portable electronic device. Here the ground plane of the circuit board 20 may be provided as a layer stretching through the whole of the circuit board. As an alternative it may only stretch through a part of the circuit board. Normally though it may be provided beneath the monopole element 24. As can be understood from fig. 2 and 3, the monopole element 24 has a length that is determined by the dimensions of the portable electronic device in which it is provided. It also has a height or distance at which it is provided from the ground plane. The height and length of the monopole element 214 in relation to the ground plane therefore defines a capacitance. As the monopole element is provided within the casing of the portable electronic device, the dimensions of this device puts constraints on the length and height of the monopole element and therefore also on the capacitance. The dimensions of the portable electronic device thus place constraints on the antenna device. This also means that for a given type of portable electronic device, like a certain device model, these constraints can be seen as being fixed.

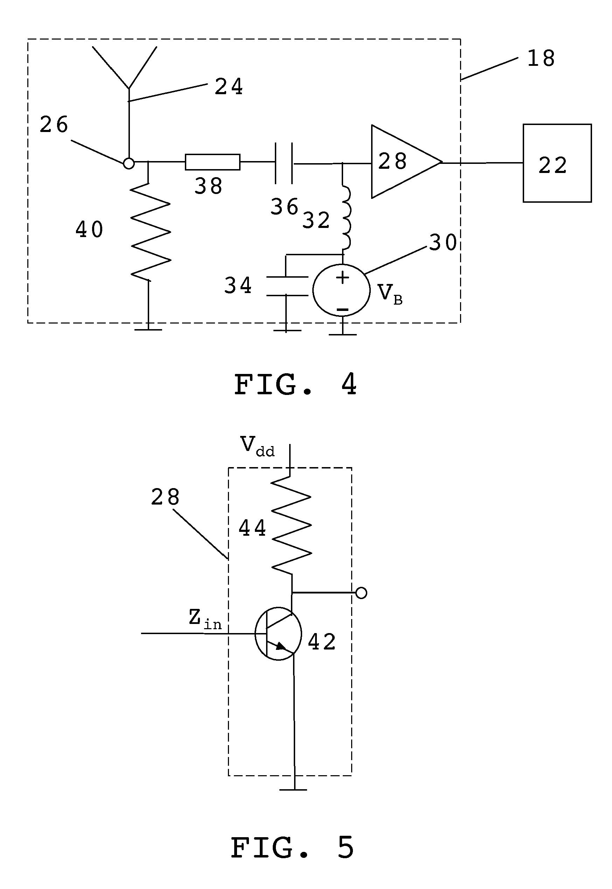

With reference to FIG. 4, the general configuration of an antenna device 18 according to a first embodiment of the present invention being connected to the radio circuit 22 is shown. The antenna device 18 here includes the monopole radiating and/or radiation receiving element 24, which may be provided in the form of a non-resonant elongated piece of electrically conductive material. It may be provided in the form of a metal wire or as a conductive trace on a flex film.

The monopole element 24 is provided with a feeding point 26, which is connected to a matching element 38. The matching element 38 is furthermore coupled to the input of an amplifier stage 28 via a first DC blocking element 36, which first DC blocking element 36 may be a capacitor. Between the input of the amplifier stage 28 and ground there is furthermore a biasing branch. This biasing branch includes a bias voltage source 30 and a choke inductor 32. The choke inductor is an rf choke that blocks rf signal leakage to and from the bias voltage source. A second DC blocking element 34 is connected between ground and the junction between the bias voltage source 30 and the choke inductor 32. This second DC blocking element 34 may also be realized as a capacitor. The bias voltage source 30 is circuitry that provides a DC voltage bias for the amplifier stage 28 and may with advantage be realized as a current mirror. This voltage source 30 is here presented as an ideal voltage source. The second DC blocking element 34 is essentially provided for creating a grounding point for the radio signals but not for the DC voltage provided by the bias voltage source 30.

The input of the amplifier stage 28 is thus coupled to the feeding point 26 of the monopole element 24 via the matching element 38 and the first DC blocking element 36. It also has an output that is connected to the FM receiver circuit 22, which could be a conventional circuit manufactured by Philips Semiconductors and sold under the name HVQFN40. The amplifier stage 28 amplifies signals received by the monopole element 24 and provides them to the FM receiver circuit 22.

Fig. 5 schematically shows a circuit diagram of one version of the amplifier stage. The amplifier stage 28 here comprises a bipolar transistor 42 with the base providing the input, the emitter connected directly to ground and the collector connectable to the input of the FM receiver circuit (not shown). There is also a load resistor 44 connected between the collector of the transistor 42 and a feed voltage Vdd. The amplifier can be a Bipolar Junction Transistor (BJT) or a Heterojunction Bipolar Transistor (HBT). As an alternative it is also possible that the amplifier stage 28 is realized as a cascode amplifier, such as the cascode amplifier described in EP1965503, but having bipolar transistors instead of Field Effect Transistors (FET). EP1965503 is herein incorporated by reference.

In order for the amplifier stage 28 to be able to operate satisfactorily the input of it needs to be biased using a DC voltage, which may be a DC voltage of zero for amplifiers based on field effect transistors but normally is about 0.7 V, especially for amplifiers based on bipolar transistors. Therefore the antenna device 18 is provided with the bias voltage source 30, which provides a biasing DC voltage V_{B} for the amplifier stage 28. However, the DC source should be isolated from the radio signal reception path stretching between the monopole element 24 and the input of the amplifier stage 28. Therefore the first DC blocking element 36 is placed in this path. This element is with advantage a capacitor having a large enough capacitance for avoiding influencing radio reception while blocking DC signals.

In order to further isolate the bias voltage source 30 from the radio reception path the choke inductor or rf choke 32 is provided. If the amplifier stage is based on bipolar transistors, as is the case in the first embodiment of the invention, this isolation has to be made using an inductor. If the amplifier stage is based on FET transistors this isolation can as an alternative be made using a large resistor. According to the present invention an inductor is always used. This inductor is with advantage as large as possible in order to provide this isolation. The inductance is then typically in the range of 470 nH. In order to provide a further safety measure for providing radio signal grounding while avoiding DC grounding the second DC blocking element 34 is provided, which is with advantage a capacitance large enough to provide ground for the radio frequencies that are of interest.

The amplifier stage 28 with bias voltage source 30, are typically provided as one entity, such as an integrated circuit. The values of the choke inductor 32 and first and second DC blocking elements 34 and 36 are then normally decided by the design and function of the amplifier stage. This means that all these elements also put constraints on the antenna device, which constraints may be seen as fixed. More particularly the choke inductor places such constraints on the antenna device. The first DC blocking element is normally large enough not to have any real influence on the antenna device in the operational frequency band, while the second DC blocking element only provides a ground connection for the choke inductor 32 at the radio frequencies of interest.

This means that for a given portable electronic device these constraints can be seen as being fixed. The consequence of the constraints will be discussed in more detail shortly.

The antenna device according to the present invention is supposed to operate in at least one frequency band. As the length and height of the monopole element is restrained by the dimensions of the portable electronic device, it is seldom possible to have an element that resonates where it is desired. The wavelengths of the operating frequency band may for instance be ten times or more longer than the electric length of the monopole element.

The present invention is based on the realization that the choke inductor and the monopole element form a resonance circuit, where the monopole element forms a capacitance C_{A} in parallel with the choke inductance. The present invention uses this inductor that is provided for another purpose to also be a part of the resonance circuit providing resonance for the antenna device in order to improve the antenna performance.

However, because of the above mentioned constraints the resonance circuit formed in this way will most likely not have a resonance frequency that is desired. Because of this the present invention proposes that the matching element is inserted in the signal path between monopole element and amplifier stage. In this way a resonance circuit is formed, of which the monopole element, choke inductor and matching element are parts, where the resonance frequency of the resonance circuit is matched to a frequency in the operating frequency band by the matching element.

This matching element can be realized as a capacitor or an inductor depending on the kind of matching that is needed.

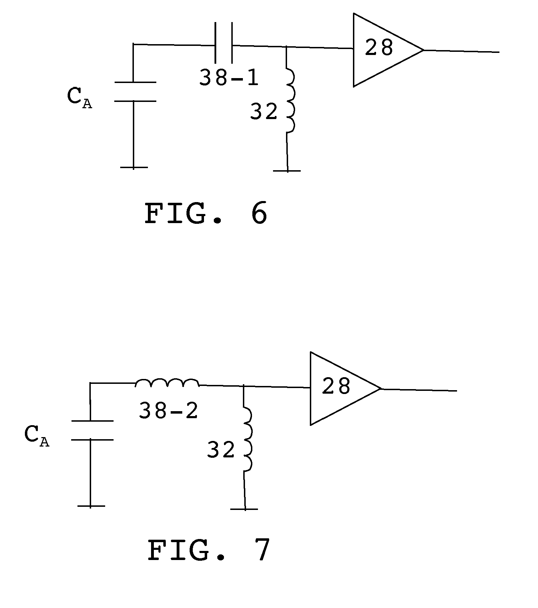

Fig. 6 shows the resonance circuit with amplifier stage in a first embodiment of the invention when the matching element is a capacitor 38-1. As can be seen the antenna element is represented by a capacitance C_{A} at one end connected to ground and at the other end coupled to the input of the amplifier stage 28 via the capacitive matching element 38-1. The capacitance C_{A} of the monopole element can therefore be seen as being connected in series with the matching element 38-1. The choke inductor 32 is in turn connected in parallel with these two elements and thus connected between ground and the input of the amplifier stage.

Fig. 7 shows the resonance circuit with amplifier stage in a second embodiment of the invention, where the only difference from fig. 6 is that the matching element 38-2 is an inductor.

The selection of type of matching element is the following. If the monopole element is too short for obtaining resonance in the desired frequency band, then an inductive matching element is selected. If the monopole element is too long, then a capacitive matching element is selected. The size of the matching element is then selected for obtaining resonance of the resonance circuit at a frequency in the desired operational frequency band.

In this way there is provided an antenna device for which resonance is obtained despite the constraints imposed on the antenna device. In fact the choke inductor, which has the purpose of blocking radio signal leakage to and from the biasing circuitry of the bias voltage source, is also put to use as a part of the resonance circuit of the antenna device. The use of the amplifier stage also provides excellent reception.

The monopole element 24 and the choke inductor 32 are in some variations of the invention co-designed with the amplifier stage 28. This means that none of them are adapted to the 50 Ω impedance normally used when connecting various elements. The reason for this is that it is very hard to adapt the impedance of a small monopole element to this type of impedance. Therefore the amplifier stage 28 is designed to have a high input impedance Zᵢₙ, which is typically ten times or more higher than 50 Ω.

The monopole element 24, matching element 38 and choke inductor 32 may thus be adapted to match the input impedance Zᵢₙ of the amplifier stage 28. These may thus be selected to provide an impedance that matches the input impedance Zᵢₙ of the amplifier stage 28.

The antenna device according to the described embodiment receives radio signals that are here FM radio signals. This antenna device is thus provided for operating in the FM frequency band. In the case of operation in the FM band, the band stretches between 88-108 MHz in Europe or between 76-110 MHz in the USA.

Through the use of a monopole element being matched to an amplifier stage using the choke inductor and matching element there is obtained an antenna that has a good isolation in relation to magnetic interference, especially as compared with magnetic dipole antennas. This is important if the portable electronic device is a cellular phone where there may exist a number of different antennas, such as GSM antennas, Bluetooth antennas and GPS antennas. This type of device furthermore often includes magnetic noise sources, such as speakers that may be driven by switched mode class D audio power amplifiers.

The resistor 40 of the antenna device has a specific purpose. It is selected large enough in order to provide a DC path from the monopole element to ground without disturbing FM signals and other high frequency signals. In this way electrostatic discharge (ESD) protection is provided that reduces interference from electro magnetic interference (EMI) and possibly signals from other antennas provided in the same radio communication device, such as cellular GSM antennas operating at frequencies well above the FM antenna.

It is preferred that the matching element 38 and amplifier stage 28 are provided relatively close to the monopole element 24 in order to minimize parasitic effects and interference from external sources.

In order for the antenna device to operate, the transistor of the amplifier stage may preferably have a minimum noise figure below 1 dB and a gain above 15 dB in the operating frequency band. Also, it is preferred that the transistors have a noise resistance Rn of less than 10 Ohms in order to achieve highest possible signal reception quality for arbitrary antenna configurations. A further preferred characteristic of the transistor is that the input capacitance is low, preferably less than 3 pF, in order to obtain high input impedance.

It is also possible to connect an FM transmitter circuit to the monopole element via a switch. This switch is necessary if the input impedance of the transmitter circuit is much lower, such as ten times lower, than the input impedance Zᵢₙ of the amplifier stage in front of the FM receiver circuit. However, this switch can be omitted if the input impedance of the transmitter circuit is in the same order as the input impedance Zᵢₙ of the amplifier stage.

By providing a transmitter circuit connected to the monopole element, this monopole element can be shared and thus function for both transmission and reception. The transmitter circuit should preferably be connected to the monopole element approximately at the feeding point.

It should here be realised that there are a number of further variations that can be made to the present invention. The monopole element may have various shapes such as being bent or meandering. However, the exact antenna configurations can be varied so as to correspond to the shape of the portable electronic device, desired performance etc.

The above-described embodiments of an antenna device according to the invention have been described as antenna devices adapted for reception of radio signals in the FM frequency band. However, other applications are also possible, such as use for digital video broad-casting (DVB) signals in the frequency range of about 400-800 MHz.

A bipolar transistor has been described as the preferred transistor type. It will be realized that other types of transistors, such as Field Effect Transistors (FET), can be used as well.

The DC blocking elements may be omitted in some variations of the invention as may also the resistor intended for ESD protection. The monopole element may finally be provided in a holding unit, such as an antenna carrier or a middle deck holding the monopole element. This holding unit may then be of a plastic material, which is easily mounted in the interior of the portable electronic device in relation to the circuit board.

## Claims

1. An antenna device (18) for receiving radio signals in at least one operating frequency band and for being provided in the interior of a portable electronic device (10), said antenna device (18) comprising
- a monopole radiating and/or radiation receiving element (24) having a capacitance (C_{A}) and including a feeding point (26),
- an amplifier stage (28) having an input coupled to the feeding point, said input of the amplifier stage being connectable to ground via a biasing branch comprising a bias voltage source (30) and a choke inductor (32), said amplifier stage having an output connectable to a radio circuit (22), and
- a matching element (38) coupled between the feeding point and the amplifier stage,
- wherein the monopole element, choke inductor and matching element are part of a resonance circuit, the resonance frequency of which is matched to a frequency in said operating frequency band by the antenna matching element.

2. The antenna device (18) according to claim 1, wherein the monopole element (24) is an elongated element.

3. The antenna device (18) according to claim 1 or 2, wherein the monopole element (24) is co-designed with the amplifier stage (28), matching element (38) and choke inductor (32).

4. The antenna device (18) according to any previous claim, wherein the impedance provided by the resonance circuit is matched to the input impedance (Zᵢₙ) of the amplifier stage (26).

5. The antenna device (18) according to any previous claim, wherein the amplifier stage (28) has an input impedance (Zᵢₙ) that is ten times or more higher than 50 Ω.

6. The antenna device (18) according to any previous claim, further comprising a DC blocking element (34) connected between ground and the junction between the choke inductor and bias voltage source.

7. The antenna device (18) according to any previous claim, further comprising a resistor (40) connected between the feeding point and ground for providing electrostatic discharge protection.

8. The antenna device (18) according to any previous claim, wherein the matching element is a capacitor (38-1).

9. The antenna device (18) according to any of claims 1 - 7, wherein the matching element is an inductor (38-2).

10. The antenna device (18) according to any previous claim, wherein the wavelengths of the operating frequency band are ten times or more longer than the electrical length of the monopole element (20).

11. The antenna device (18) according to any previous claim, wherein the operating frequency band is the FM band.

12. The antenna device (18) according to any previous claim, wherein the amplifier stage (26) includes one or more bipolar transistors (42).

13. The antenna device (18) according to claim 12, wherein said bipolar transistors are BJT or HBT transistors.

14. A portable electronic device (10) comprising in its interior,
- an antenna device (18) according to any of claims 1 - 13 for receiving radio signals in at least a first operating frequency band, and
- a radio circuit (22) connected to the antenna device.

15. A portable electronic device (10) according to claim 14, wherein the monopole element (24) is co-designed with the amplifier stage (28), matching element (38) and choke inductor (32).

16. A portable electronic device (10) according to claim 14 or 15, wherein the impedance provided by the resonance circuit is matched to the input impedance (Zᵢₙ) of the amplifier stage (28).

17. A portable electronic device (10) according to any of claims 14 - 16, wherein the amplifier stage (28) has an input impedance (Zᵢₙ) that is ten times or more higher than 50 Ω.

18. A portable electronic device (10) according to any of claims 14 - 17, further comprising a DC blocking element (34) connected between ground and the junction between the choke inductor and bias voltage source.

19. The portable electronic device according to any of claims 14 - 18, further comprising a resistor (40) connected between the feeding point and ground for providing electrostatic discharge protection.

20. The portable electronic device according to any of claims 14 - 19, wherein the matching element is a capacitor (36-1) or an inductor (36-2).

21. The portable electronic device according to any of claims 14 - 20, wherein the amplifier stage (28) includes one or more bipolar transistors (42).
